# FASCICULE DE BREVET EUROPEEN

(11) **EP 2 389 691 B1**
(45) Date de publication et mention de la délivrance du brevet: **25.09.2013**
(21) Numéro de dépôt: 10701139.7
(22) Date de dépôt: 21.01.2010
(51) Int. Cl.: H01L 31/055, H01L 31/058

(54) **Convertisseur photovoltaïque à durée de vie augmentée**
Photovoltaikwandler mit vergrösserter Lebensdauer
Photovoltaic converter with increased life span

(30) Priorité: 26.01.2009 FR 0950452
(43) Date de publication de la demande: 30.11.2011
(73) Titulaire: COMMISSARIAT A L'ENERGIE ATOMIQUE ET AUX ENERGIES ALTERNATIVES, 75015 Paris (FR)
(72) Inventeur: GRUSS, Jean-Antoine, F-38170 Seyssinet (FR); JAUSSAUD, Claude, F-38240 Meylan (FR); PONCELET, Olivier, F-38000 Grenoble (FR)
(74) Mandataire: Ilgart, Jean-Christophe
(86) Numéro de dépôt international: PCT/EP2010/050672
(87) Numéro de publication internationale: WO 2010/084145

(56) Documents cités:
- EP-A- 0 091 625
- DE-A1- 2 501 907
- DE-A1- 3 036 269
- US-A- 3 291 749
- US-A- 4 135 537

## Description

### DOMAINE TECHNIQUE ET ART ANTÉRIEUR

La présente invention se rapporte à un dispositif de conversion photovoltaïque à durée de vie augmentée.

Différents types de cellules photovoltaïques peuvent être utilisés dans un dispositif de conversion photovoltaïque.

Certaines cellules sont réalisées à partir de silicium monocristallin, de silicium polycristallin ou de silicium amorphe, les cellules pouvant être massives ou formées de couches minces.

D'autres cellules sont réalisées en film mince par dépôt de type CIS (Cuivre Indium Sélénium) ou CdTe (Tellurure de cadmium) sur du verre ou du métal.

D'autres cellules encore sont de type organique déposées sur du verre ou sur un film flexible.

Des inconvénients sont liés la réalisation et à l'utilisation de ces cellules.

Dans le cas des cellules à base de silicium, celles-ci sont relativement coûteuse, du fait, à la fois, du coût du silicium et de leur procédé de réalisation. Il est possible de réduire la quantité de silicium nécessaire à la réalisation d'une cellule, en utilisant un concentrateur mais le coût de celui-ci est également élevé. Par ailleurs, des matériaux polymères sont généralement mis en oeuvre dans la structure des modules photovoltaïques à base de silicium, or ceux-ci sont sensibles au rayonnement ultraviolet et à l'humidité, la durée de vie de tels dispositifs est donc réduite.

Le problème de la durée de vie apparaît également dans le cas des cellules organiques, du fait des rayonnements ultraviolets et de l'humidité.

Par ailleurs, le rayonnement électromagnétique, auquel sont soumises les cellules, et plus généralement le dispositif photovoltaïque, émet également dans l'infrarouge. Or, les cellules ne sont généralement pas capables de convertir les photons émis dans l'infrarouge. Ce rayonnement est alors uniquement responsable d'un échauffement du dispositif. Cet échauffement provoque une baisse du rendement de conversion et peut endommager les cellules et réduire leur durée de vie.

Par ailleurs, les dispositifs de conversion photovoltaïques actuels ne produisent de l'électricité que lorsque leurs cellules reçoivent un rayonnement. Ce qui signifie qu'en période de faible ensoleillement, typiquement la nuit, il n'y a pas de production d'électricité. Ceci est particulièrement gênant dans le cas de systèmes disposés dans des sites isolés et alimentés par un dispositif photovoltaïque. Il faut alors prévoir des moyens de stockage d'une partie de l'électricité produite pendant la période d'ensoleillement, tels que des accumulateurs au plomb. Or ce type d'accumulateur a un coût d'achat et de maintenance élevé. Par ailleurs, ces accumulateurs posent des problèmes de toxicité.

Il existe des dispositifs de conversion photovoltaïques capables également de valoriser l'échauffement provoqué par le rayonnement infrarouge, par exemple le document US 4 135 537. Ces dispositifs comportent un boîtier muni d'une face transparente aux rayons lumineux et de capteurs photovoltaïques pour convertir les rayonnements lumineux en électricité. Le boîtier est couplé à un circuit muni d'un échangeur thermique, et un fluide chargé de particules luminescentes circule dans le boîtier et dans l'échangeur thermique pour collecter la chaleur captée par le fluide lors de son passage dans le boîtier.

Ce dispositif prévoit de refroidir les cellules par circulation du fluide. Cependant, les cellules sont toujours échauffées par le rayonnement infrarouge.

Par ailleurs, se pose toujours le problème de la génération d'électricité en périodes de faible ensoleillement. En outre, les cellules du document US 4 135 537 sont directement soumises au rayonnement ultraviolet.

C'est par conséquent un des buts de la présente invention d'offrir un dispositif photovoltaïque à durée de vie augmentée.

### EXPOSÉ DE L'INVENTION

Le but énoncé ci-dessus est atteint par un dispositif de conversion photovoltaïque comportant une première zone dans laquelle le rayonnement lumineux est capté et une deuxième zone munie de cellules photovoltaïques destinées à convertir le rayonnement lumineux en électricité, le transfert de la zone de captation vers la zone de conversion s'effectue au moyen de particules photoluminescentes.

De manière avantageuse, en utilisant des particules photoluminescentes phosphorescentes, la réémission des photons se fait avec un certain retard, la conversion en énergie électrique est alors différée. On peut donc envisager de générer de l'électricité en dehors d'une période d'ensoleillement.

Par conséquent, les cellules photovoltaïques ne sont plus soumises directement au rayonnement lumineux. Il en résulte que les cellules ne sont plus échauffées directement par le rayonnement infrarouge. Par ailleurs, les cellules solaires ne sont plus soumises au rayonnement ultraviolet puisque les photons réémis pas les particules photoluminescentes sont dans le spectre visible. La durée de vie des cellules est donc augmentée.

On peut également prévoir des moyens pour récupérer la chaleur transportée par le fluide contenant les particules photoluminescentes.

La présente invention a pour objet un dispositif de conversion photovoltaïque comportant une zone de captation des photons apportés par le rayonnement lumineux et une zone de conversion desdits photons en énergie électrique, la zone de captation et la zone de conversion étant formées par des enceintes distinctes, un fluide chargé de particules photoluminescentes étant destiné à circuler entre la zone de captation et la zone de conversion, lesdites particules absorbant les photons et étant transportées jusqu'à la zone de conversion dans laquelle a lieu une réémission des photons par les particules.

De manière particulièrement avantageuse, les particules photoluminescentes sont des particules phosphorescentes. Ce sont par exemple des sulfures ou des séléniures ou des phosphores de type oxyde, et plus particulièrement des sulfures de zinc ou des aluminates d'alcalino-ferreux dopé.

Le fluide peut être, quant à lui, un alcane ou un perfluroalcane.

On choisit, par exemple une concentration en masse des particules photoluminescentes comprise entre 0,1% et 30%.

Le fluide peut avantageusement comporter également des nanoparticules permettant l'apparition du phénomène de « quantum cutting » et/ou favorisant la conversion de longueur d'onde des photons réémis de l'ultraviolet vers le visible.

Plus particulièrement, l'enceinte de la peut comporter au moins une face transparente au rayonnement lumineux et l'enceinte de la zone de conversion photovoltaïque peut avoir une partie au moins des faces intérieures de ses structures internes recouvertes de cellules photovoltaïques, chaque enceinte comportant un orifice d'alimentation et un orifice d'évacuation du fluide, l'orifice d'évacuation d'une enceinte étant connecté à l'orifice d'alimentation de l'autre enceinte.

De manière avantageuse, le dispositif de conversion photovoltaïque selon l'invention peut comporter un échangeur thermique, ce qui permet à la fois d'augmenter le rendement de conversion photovoltaïque par refroidissement du fluide avant son entrée dans le convertisseur et de récupérer l'énergie thermique.

Dans un mode de réalisation, la zone de conversion comporte au moins une plaque de silicium dans laquelle sont gravés des canaux de circulation du fluide, les matériaux de la plaque et de la surface des canaux formant des jonctions p-n. Dans un exemple de réalisation, les canaux sont, par exemple contenus dans le plan de la plaque. Dans un autre exemple de réalisation, les canaux sont traversants et orthogonaux au plan de la plaque de sorte à former une membrane perforée. Ainsi par structures internes, on entend par exemple un assemblage de plaques.

Le dispositif de conversion photovoltaïque selon l'invention peut comporter un empilement d'au moins deux plaques. Les plaques de l'empilement peuvent être alimentées avec le fluide en parallèle.

On peut alors prévoir de disposer un échangeur thermique interposé entre chaque paire de plaques de l'empilement.

Dans un autre mode de réalisation, la zone de conversion comporte des cellules photovoltaïques réalisées en film mince de polymère organique ou de CIS de CIGS ou de CdTe déposé sur métal ou sur verre.

Dans un exemple de réalisation, le dispositif comporte des canaux délimités par les films minces.

Dans un autre exemple de réalisation, le film mince est enroulé sur lui-même délimitant un canal en forme de spiral.

Le dispositif comporte avantageusement des entretoises entre les différents enroulements du film de sorte à maintenir écartés deux enroulements du film pour ménager le canal, celles-ci étant soit rapportées entre les enroulements, soit formées dans le film par gaufrage ou bossage de celui-ci.

Dans une variante de réalisation, le dispositif de conversion photovoltaïque selon l'invention comporte deux canaux enroulés l'un autour de l'autre obtenus par pliage du film mince sur lui-même et par enroulage de ce film plié, l'un des canaux étant destiné à la circulation du fluide chargé en particules photoluminescentes et l'autre canal étant destiné à la circulation du fluide caloporteur.

La circulation du fluide est par exemple réalisée par effet thermosiphon ou au moyen d'une pompe électrique alimentée directement par l'électricité produite par les cellules photovoltaïques.

On peut prévoir de disposer l'échangeur thermique entre la zone de captation et la zone de conversion, en amont de la zone de conversion

La présente invention a également pour objet un procédé de réalisation d'un dispositif de conversion photovoltaïque selon la présente invention, comportant les étapes de réalisation de la zone de conversion suivantes :
- gravure de canaux dans un substrat en silicium dopé p ou n,
- réalisation d'un dopage de type n ou p de la face intérieure des canaux, formant ainsi des zones émettrices de type n ou p et des zones collectrices de type p ou n,
- dépôt d'électrodes sur les zones émettrices et collectrices,
- recuit de ladite structure ainsi formée.

Le procédé peut également comporter l'étape de dépôt d'un matériau anti-réfléchissant avant l'étape de dépôt des électrodes.

Il peut également comporter l'étape d'assemblage de plusieurs plaques empilées par collage ou brasure.

La présente invention a également pour objet un procédé de réalisation d'un dispositif de conversion photovoltaïque selon la présente invention comportant les étapes de :
- réalisation d'un film en polymère organique en en CIS, CIGS ou CdTe déposé sur métal ou sur verre, par exemple par un procédé en continu de type « roll to roll »,
- enroulage du film sur lui-même en laissant un jeu entre les différentes couches de l'enroulement.

Avantageusement, ce procédé comporte l'étape de structuration du film formant entretoises ou de mise en place d'éléments formant entretoises sur le film préalablement à l'enroulage du film pour former un relief permettant d'assurer la présence du jeu entre les différents enroulements.

Dans une variante de réalisation, le procédé de réalisation d'un dispositif de conversion photovoltaïque selon l'invention comporte l'étape de pliage en deux du film sur lui-même préalablement à son enroulage pour ménager deux canaux enroulés l'un autour de l'autre.

### BRÈVE DESCRIPTION DES DESSINS

La présente invention sera mieux comprise sur la base de la description qui va suivre et des dessins en annexe sur lesquels :
- la figure 1 est une représentation schématique d'un système de conversion photovoltaïque selon la présente invention,
- la figure 2 est une vue de détail d'un exemple de réalisation d'un convertisseur photovoltaïque à base de silicium pouvant être mis en oeuvre dans le système de la figure 1, le convertisseur étant muni de canaux,
- la figure 3 est une vue de côté d'un convertisseur de la figure 2 formé de plusieurs couches,
- la figure 4 est une vue de détail d'un autre exemple de réalisation d'un convertisseur photovoltaïque à base de silicium pouvant être mis en oeuvre dans le système de la figure 1, le convertisseur prenant la forme d'une membrane,
- la figure 5 est une vue de détail d'une variante du convertisseur de la figure 4,
- la figure 6A est une vue de dessus du convertisseur de la figure 4,
- la figure 6B est une vue de côté d'un convertisseur comportant une pluralité de membranes empilées selon la figure 4,
- la figure 7 est une vue de dessus d'un autre exemple d'un convertisseur photovoltaïque à base de films minces pouvant être mis en oeuvre dans le système de la figure 1,
- les figures 8A et 8B sont des vues d'une variante du convertisseur de la figure 7,
- la figure 9 est une vue en perspective d'un autre exemple de réalisation d'un convertisseur à base d'un film mince pouvant être mis en oeuvre dans le système de la figure 1,
- la figure 10 est une vue de côté d'une variante du convertisseur de la figure 9.

### EXPOSÉ DÉTAILLÉ DE MODES DE RÉALISATION PARTICULIERS

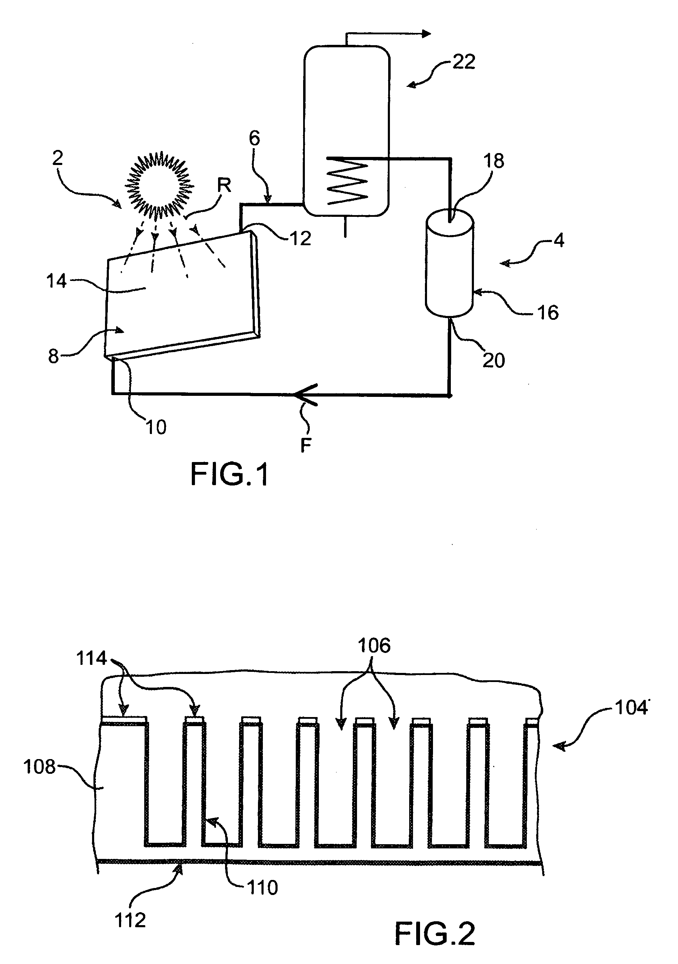

Sur la figure 1, on peut voir une représentation schématique d'un système de conversion photovoltaïque selon la présente invention comportant un capteur de rayonnement lumineux 2, un convertisseur photovoltaïque 4 séparé du capteur 2 et un circuit étanche 6 pour la circulation d'un fluide entre le capteur 2 et le convertisseur 4.

Dans toute la description, la circulation du fluide est symbolisée par les flèches F.

Le capteur de rayonnements lumineux 2 comporte une enceinte 8 délimitant un espace destiné à contenir un fluide, un orifice d'entrée d'alimentation 10 en fluide et un orifice d'évacuation 12 du fluide pour permettre la circulation du fluide à travers l'espace intérieur. Au moins une paroi 14 de l'enceinte 8 est transparente au rayonnement lumineux R permettant au fluide circulant dans l'enceinte d'être exposé au rayonnement lumineux. Dans l'exemple représenté, le rayonnement lumineux provient du soleil, mais d'autres sources sont envisageables.

Le convertisseur photovoltaïque comporte également une enceinte 16 délimitant un espace dans lequel circule le fluide provenant du capteur de rayonnement lumineux 2. Cette enceinte 16 comporte, de manière similaire à l'enceinte 8 du capteur de rayonnement lumineux 2, un orifice d'alimentation 18 en fluide et un orifice d'évacuation 20 du fluide.

L'enceinte 16 comporte sur les faces intérieures de ses parois qu'on appellera structures internes des cellules photovoltaïques (non visibles) destinées à capter les photons réémis dans toutes les directions de l'espace, comme nous le verrons dans la suite de la description. L'enceinte 16 n'a pas besoin de comporter de paroi externe transparente, toutes ses parois peuvent alors être recouvertes de cellules photovoltaïques, ce qui permet d'augmenter le taux de collecte des photons réémis, comme nous le verrons par la suite.

L'orifice d'évacuation 8 de l'enceinte du capteur de rayonnements lumineux 2 est relié à l'orifice d'alimentation 16 de l'enceinte du convertisseur photovoltaïque 4, et l'orifice d'évacuation 18 de l'enceinte du convertisseur photovoltaïque est relié à l'orifice d'alimentation 12 du capteur de rayonnement lumineux 2.

Les deux enceintes peuvent être disposées côté à côte ou à distance l'une de l'autre, dans ce cas, des tuyaux sont prévus.

Le fluide est chargé de particules photoluminescentes en suspension. Le fluide peut être un gaz ou un liquide. Le fluide porteur est choisi de sorte à ne pas être conducteur électrique afin d'éviter une mise en court-circuit des électrodes. Il peut s'agir par exemple d'un alcane stable ou d'un perfluoroalcane.

Les matériaux photoluminescents présentent la propriété d'absorber les photons dans un large spectre de rayonnement électromagnétique, ils absorbent à la fois dans le spectre visible et dans le spectre ultraviolet, et de réémettre les photons absorbés dans le spectre visible. En outre, ces matériaux réémettent dans toutes les directions. Comme décrit ci-dessus, l'enceinte 16 pouvant comporter des cellules photovoltaïques sur toutes les faces intérieures de ses structures internes, les photons réémis dans les trois directions peuvent être efficacement collectés.

Le fluide circule dans le système entre le capteur solaire 2 et le convertisseur photovoltaïque 4, par exemple au moyen d'une pompe ou par effet thermosiphon.

Dans l'exemple représenté, le système comporte également un échangeur thermique 22 monté dans le circuit 8 entre le capteur de rayonnements lumineux 2 et le convertisseur photovoltaïque, en amont du convertisseur dans le sens de circulation du fluide. Cet échangeur 22 est destiné à prélever la chaleur transportée par le fluide. Dans cet exemple avantageux, une récupération de chaleur est en plus effectuée. L'efficacité énergétique du système selon l'invention est donc encore augmentée. Cette disposition permet également de refroidir le fluide avant qu'il ne pénètre dans le convertisseur, les effets de la chaleur sur son rendement et sa durée de vie sont donc limités.

Cet échangeur thermique peut être du type serpentin circulant dans un ballon d'eau chaude et permettant de produire l'eau chaude d'une habitation. On pourrait également prévoir de disposer cet échangeur 22 entre le convertisseur photovoltaïque et le capteur de rayonnements lumineux 2.

Nous allons maintenant expliquer le fonctionnement du système de conversion photovoltaïque selon la présente invention.

Le système est rempli de fluide chargé de particules photoluminescentes, i.e. l'enceinte 8 du capteur de rayonnements lumineux 2, l'enceinte 16 du convertisseur photovoltaïque et les conduits reliant le capteur 2 et le convertisseur 4. Le volume de fluide se trouvant dans le capteur 2 est exposé au rayonnement lumineux. Les photons dont la longueur d'onde se trouve dans les spectres visible et ultraviolet sont absorbés par les particules photoluminescentes à un instant t. Le volume de fluide est en outre échauffé par le rayonnement infrarouge.

Le volume de fluide circule dans le circuit et rejoint le convertisseur photovoltaïque 4. Les particules photoluminescentes réémettent à un instant t + x des photons dans le spectre visible, ces photons sont captés par les cellules photovoltaïques situées dans les structures internes de l'enceinte 16. Comme expliqué précédemment, les photons réémis le sont dans toutes les directions de l'espace, la présence de cellules sur toutes les faces intérieures des structures internes de l'enceinte 16 permet d'optimiser la collecte de photons. Ces photons sont alors convertis en électricité. On peut également faire circuler le fluide en permanence, indépendamment du temps écoulé entre la captation des photons et leur réémission.

Il est à noter que le fluide se déplaçant dans le dispositif de manière continue, la captation des photons par les particules phosphorescentes s'effectue en continu, ainsi que leur réémission. On obtient donc une génération de courant en continu.

Grâce à l'invention, le convertisseur 4 n'est pas exposé directement au rayonnement lumineux, par ailleurs les photons réémis le sont dans le spectre visible. Par conséquent, le convertisseur et plus particulièrement les modules photovoltaïques ne sont donc pas exposés au rayonnement ultraviolet. Par conséquent, la durée de vie des polymères utilisés pour la réalisation du convertisseur est augmentée par rapport aux convertisseurs de type connu. Dans le cas de cellules photovoltaïques en polymère organique, leur durée de vie est également augmentée, puisqu'elles sont, elles aussi, très sensibles au rayonnement ultraviolet.

Par ailleurs, le convertisseur photovoltaïque 4 n'étant pas directement exposé au rayonnement lumineux, il n'est pas exposé au rayonnement infrarouge. L'échauffement des cellules est donc limité et n'est dû qu'à l'échauffement du fluide lui-même lors de son exposition au rayonnement lumineux. Le rendement des cellules n'est donc pas pénalisé. De plus, en prévoyant un échangeur de chaleur en amont du convertisseur 4, la température du fluide est encore abaissée, préalablement à son entrée dans le convertisseur 4.

De manière particulièrement avantageuse, on prévoit d'utiliser comme particules photoluminescentes, des particules phosphorescentes.

La phosphorescence est un type particulier de photoluminescence dans lequel le phénomène de réémission est différé temporellement. Les photons absorbés passent par des états d'énergie intermédiaire, typiquement des états triplets (interdits), le retour inévitable des photons piégés de ces états interdits au niveau de basse énergie est cinétiquement défavorisé, ce qui a pour effet de ralentir l'émission lumineuse, c'est ainsi que la réémission de l'énergie absorbée pour la plupart des matériaux phosphorescents est de l'ordre de la milliseconde. Il est possible d'avoir des états triplets dont la durée de vie est de plusieurs heures, ce qui implique une réémission des photons plusieurs heures après leur absorption.

Cette réémission « différés » a pour avantage d'avoir une génération d'électricité en l'absence de rayonnement lumineux. En effet, les photons « capturés » par les particules phosphorescentes lors d'une période d'ensoleillement, typiquement le jour, sont réémis la nuit dans le convertisseur qui génère alors de l'électricité, ceci particulièrement dans le cas d'une réémission « différée » de plusieurs heures.

Le convertisseur peut fonctionner en permanence, en utilisant la forte rémanence des matériaux phosphorescents, les photons étant réémis jusqu'à 12 heures après leur exposition. Ceci permet alors, dans le cas où une alimentation électrique sensiblement constante est requise 24h sur 24h, de réduire la capacité des batteries de stockage, voir de les supprimer.

On peut prévoir de faire circuler le fluide en permanence dans le circuit. Lorsqu'une pompe électrique est utilisée, l'électricité requise pour entraîner cette pompe peut être directement celle générée par le système de conversion selon la présente invention.

De manière également avantageuse, on peut prévoir d'ajouter dans le fluide des nanoparticules permettant l'apparition du phénomène de « quantum cutting » afin d'augmenter le rendement des cellules. Le « quantum cutting » est un mécanisme permettant, à partir d'un photon émettant dans l'ultraviolet, de donner deux photons émettant dans le visible ou dans un spectre proche de l'infrarouge. Le rendement théorique d'une cellule peut alors passer de 30 % à 40%.

Les particules phosphorescentes convertissent des photons haute énergie (UV) en photons de basse énergie (visible) en différant cette réémission dans le temps.

Dans le cas de particules phosphorescentes, la durée de vie de ces états triplets peut dépasser plusieurs heures. Ces phénomènes étant « lents », il n'y a peu de quenching (i.e. extinction de luminescence), le domaine d'excitation est donc plus «efficace».)

A titre d'exemple, on peut choisir comme matériaux phosphorescents des sulfures ou des séléniures tels que le sulfure de cadmium ou le sulfoséléniures ou les sulfures, sulfoséléniures, oxysulfures d'alcalino-terreux.

On peut également choisir des particules parmi la famille des phosphores de type oxyde tels que les aluminates, les gallates, les silicates et germanates, les halophosphates et phosphates, les arséniates, les vanadates, les niobiates, les tantalates, les sulfates, les tungstates, les molybdates ainsi que parmi les phosphores de type halogénures métalliques.

Ces matériaux présentent l'avantage d'absorber à la fois dans l'infrarouge et l'ultraviolet de réémettre dans le visible, dans le rouge ou le vert.

De manière particulièrement avantageuse, on peut choisir les sulfures de zinc et les aluminates d'alcalino-terreux (Sr) dopé avec des terres rares. Ces derniers permettent de contrôler le domaine d'émission des photons de fluorescence, ce qui permet d'adapter l'émission des photons en fonction de la bande d'émission dans laquelle le convertisseur est le plus efficace.

On peut aussi utiliser des matériaux phosphorescents inorganiques présentant avantageusement des rendements quantiques plus élevés et étant peu sensibles à la chaleur.

La taille des particules est avantageusement comprise entre 0,1 µm et 1 µm, avec une concentration par exemple comprise entre 0,1% à 30% en masse.

Nous allons maintenant décrire différents exemples de réalisation de convertisseurs photovoltaïques pouvant être utilisés dans le système de conversion photovoltaïque selon la présente invention.

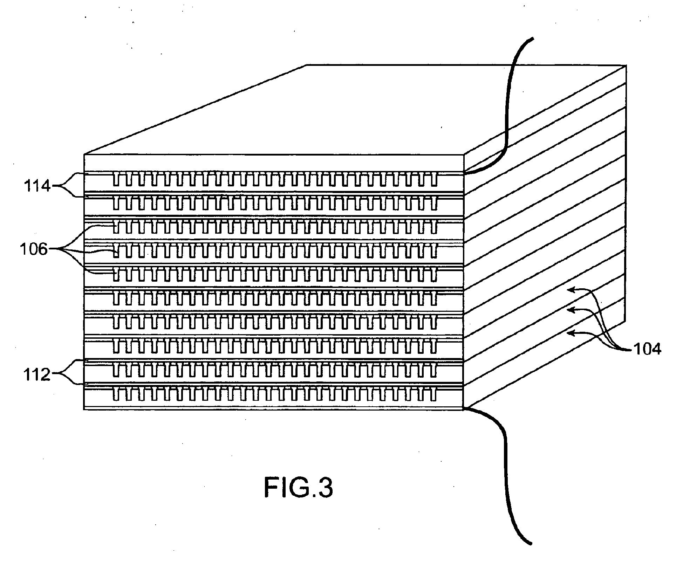

Sur les figures 2 et 3, on peut voir un exemple de réalisation d'un convertisseur photovoltaïque 104 permettant une collecte optimisée des photons émis dans les trois dimensions.

Ce convertisseur comporte des canaux 106 gravés dans un substrat 108 en silicium sous forme de plaque, les canaux étant contenus dans le plan de la plaque. Le fluide est destiné à s'écouler dans les canaux dont une première extrémité longitudinale est connectée à l'orifice d'alimentation de l'enceinte du convertisseur et dont une deuxième extrémité est connectée à l'orifice d'évacuation de l'enceinte du convertisseur. Le fluide est donc destiné à s'écouler dans le plan de la plaque.

Dans l'exemple représenté, le substrat 108 dans lequel sont gravés les canaux 106 est dopé n, puis on effectue un dépôt de silicium dopé p 110 sur le substrat 108, le silicium dopé p recouvrant l'intérieur des canaux. On crée ainsi des jonctions p-n qui, lorsqu'elles seront bombardées par les photons réémis par les particules transportées par le fluide s'écoulant dans les canaux, générerons de l'électricité de manière connue par l'homme du métier.

Une première électrode 112 est déposée sur une face arrière de la plaque en contact avec le substrat dopé n, et une deuxième électrode 114 est déposée sur une face avant de la plaque en contact avec la couche de silicium dopé p, cette face étant formée notamment par le haut des canaux.

Sur la figure 3, on peut voir un convertisseur photovoltaïque 116 formé par un empilement de convertisseurs 104 de base similaires à la plaque représentée sur la figure 2. Ce convertisseur présente l'avantage d'offrir une très grande surface de captation des photons réémis par le fluide.

Dans l'exemple représenté, les plaques sont connectées électriquement en série. De manière avantageuse, ces connexions sont obtenues simplement en mettant en contact direct une électrode positive d'une plaque avec une électrode négative de la plaque suivante. Le raccordement au dispositif utilisateur ou au dispositif de stockage s'effectue alors simplement par les électrodes d'extrémité du dispositif. Le nombre de connexions est donc considérablement réduit. On peut bien entendu réaliser une connexion en parallèle des plaques de convertisseur.

On peut prévoir, dans cet exemple de réalisation, d'alimenter simultanément les différentes plaques du convertisseur par du fluide provenant du capteur de rayonnement, ou alors de faire circuler le fluide en série de plaques en plaques grâce à des distributeurs de fluides intégrés aux plaques afin de collecter la quantité maximale de photons.

L'alimentation et l'évacuation du fluide s'effectuent par exemple par deux piquages verticaux, orthogonaux au plan des plaques.

Dans l'exemple représenté, les canaux des différentes plaques sont orthogonaux entre eux. On pourrait cependant prévoir de croiser les canaux des sortes que les canaux d'une plaque soient orthogonaux aux canaux des plaques supérieure et inférieure, l'alimentation des plaques étant croisée.

On pourrait prévoir également d'intégrer directement l'échangeur thermique au sein du convertisseur, celui-ci étant prévu entre chaque paire de plaques, la chaleur étant évacuée en même temps que les photons réémis sont convertis par les cellules photovoltaïques.

Nous allons maintenant décrire un procédé de réalisation d'un convertisseur du type représenté sur les figures 2 et 3.

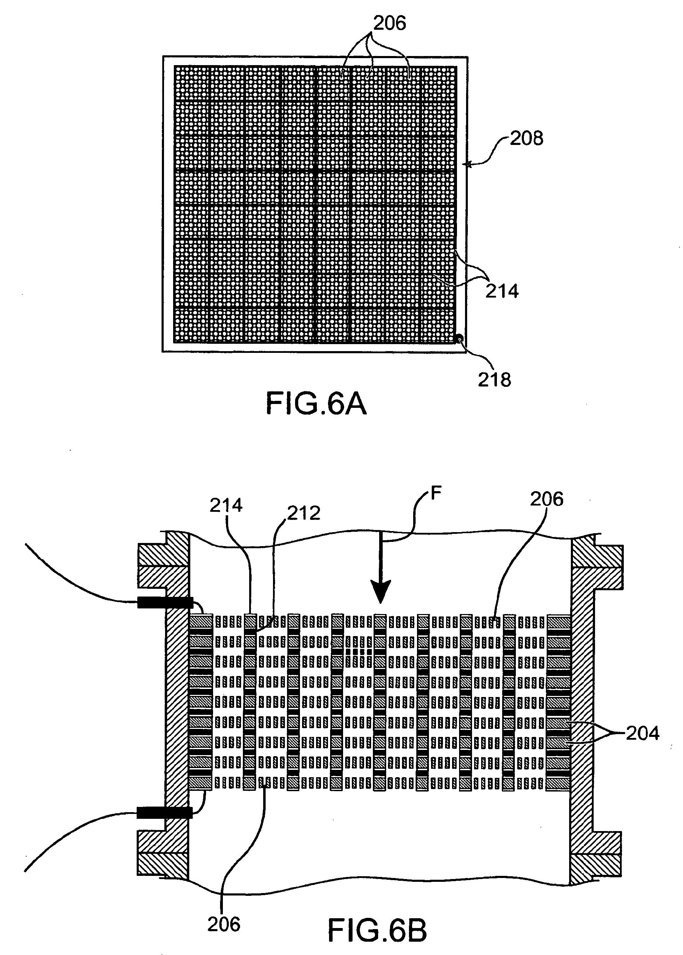

Le procédé comporte les étapes suivantes :
- on réalise la gravure des canaux 106 dans un substrat en silicium 108 dopé p (ou n) à l'aide d'un technique connue, telle que le sciage mécanique, la gravure sèche ou humide, comme par exemple la gravure KOH, TMAH, RIE, la gravure laser, la gravure électrochimique ou tout autre procédé de gravure connu dé l'homme de l'art.
- on effectue ensuite un dopage n (ou p) des canaux 106 et sur le dessus du substrat 108, les jonctions p-n sont ainsi formées. On pourrait, dans une variante de réalisation, réaliser l'émetteur par dépôt de silicium amorphe dopé.
- On effectue ensuite un dépôt d'une couche de matériau anti-réfléchissant, tel que le nitrure de silicium, ou TCO (oxyde transparent conducteur) dans le cas des cellules film mince.
- On dépose ensuite les électrodes métalliques 112, 114. L'électrode 112 sur l'émetteur de type n est par exemple en argent, et l'électrode 114 sur collecteur de type p est par exemple en aluminium
- On pourrait envisager de ne pas déposer d'électrodes sur le haut des canaux et de limiter le dépôt à des zones non pourvues de canaux. Dans ce cas, des zones sans canaux sont réalisées périodiquement afin de collecter efficacement le courant, de manière similaire à l'électrode 214 sur la figure 6A.
- On effectue ensuite un recuit 850°C de la structure ainsi réalisée.

Dans le cas où on réalise une structure similaire à celle de la figure 3, on empile les différentes plaques et on les assemble par exemple, par collage, par brasure.... Comme expliqué ci-dessus, les plaques sont connectées électriquement entre elles par contact direct des électrodes des plaques successives, l'assemblage permet donc de connecter électriquement des cellules entre elles de manière simple.

A titre d'exemple, on peut utiliser un substrat dont l'épaisseur est comprise entre 250 µm et 1000 µm, avantageusement celle-ci peut être égale à 600 µm. Les canaux ont une profondeur de 500 µm et une largeur comprise ente 50 µm et 500 µm, avantageusement celle-ci est égale à 50 µm.

La largeur des parois de séparation entre les canaux est comprise entre 10 µm et 500 µm, et est avantageusement égale à 20 µm.

L'épaisseur de la couche de silicium dopé n (ou p) est typiquement de 500 nm.

Les électrodes 112, 114 ont une épaisseur de 10 µm.

Dans le cas d'une électrode 114 ne recouvrant pas les sommets de canaux, et où des zones sans canaux sont réalisées périodiquement, celles-ci peuvent être réalisées typiquement tous les 5 mm.

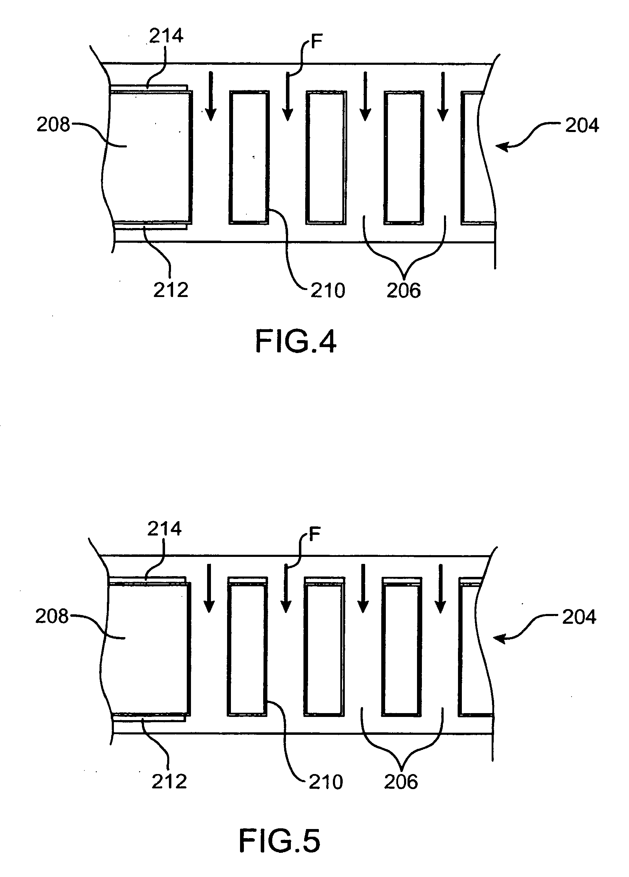

Sur les figures 4 à 6B, on peut voir un autre exemple de réalisation d'un convertisseur photovoltaïque 204 selon la présente invention.

Le convertisseur comporte également des canaux 206 réalisés dans un substrat en silicium 208, cependant, contrairement aux canaux du convertisseur de la figure 2, ceux-ci sont réalisés de telle sorte que l'écoulement du fluide ait lieu dans une direction orthogonale au plan du substrat, symbolisé par les flèches 216.

Les canaux 206 sont donc gravés dans le substrat de sorte à former des passages traversant d'axe sensiblement orthogonal au plan du substrat 208. Il est bien entendu que des canaux d'axe incliné par rapport au plan du substrat ne sortent pas du cadre de la présente invention.

Dans l'exemple représenté, le substrat 208 dans lequel sont gravés les canaux 206 est dopé n, puis on effectue un dépôt de silicium dopé p 210 sur le substrat 208, le silicium dopé p recouvrant l'intérieur des canaux.

On effectuer ensuite le dépôt des électrodes 212 et 214 sur les faces avant et arrière du substrat.

Les électrodes peuvent être déposées uniquement sur les bords de la plaque (figure 4), ou sur toute la surface de la face arrière et de la face avant, ce qui facilite la collecte des électrons.

Le convertisseur forme alors une membrane percée d'une multitude de canaux, destinée à être traversée par le fluide.

Sur la figure 6A, on peut voir une vue de dessus d'un convertisseur de la figure 4 avec l'électrode 214 quadrillant la surface de la membrane. La connexion de l'électrode aux moyens de collecte des électrons est désignée par la référence 218.

Sur la figure 6B, on peut voir un convertisseur formé par un empilement de membranes similaires à celle de la figure 4 ou 5. De manière similaire à l'empilement de la figure 3, les membranes sont connectées électriquement en série et deux connexions vers les moyens de collecte seulement sont requises.

Dans ce convertisseur photovoltaïque, l'écoulement s'effectue d'une extrémité du convertisseur vers l'autre extrémité. Le fluide photoluminescent traverse successivement les différentes membranes et les photons réémis sont captés.

Le procédé de réalisation du convertisseur des figures 4 et 5 est très proche de celui des figures 2 et 3. Celui-ci diffère par le fait que l'on grave des passages traversants et non des canaux contenus dans le plan du substrat, cependant les moyens de gravure utilisés sont similaires à ceux utilisés pour le convertisseur des figures 2 et 3.

Les passages ont par exemple un diamètre compris entre 20 µm et 100 µm, celui-ci est avantageusement égal à 50 µm.

Dans le cas de la structure de la figure 6A, les zones sans passages sont par exemple réalisées tous les 5 mm.

Dans le cas de la réalisation d'un empilement tel que celui de la figure 6B, l'assemblage peut être réalisé par adhésion moléculaire, collage ou brasure.

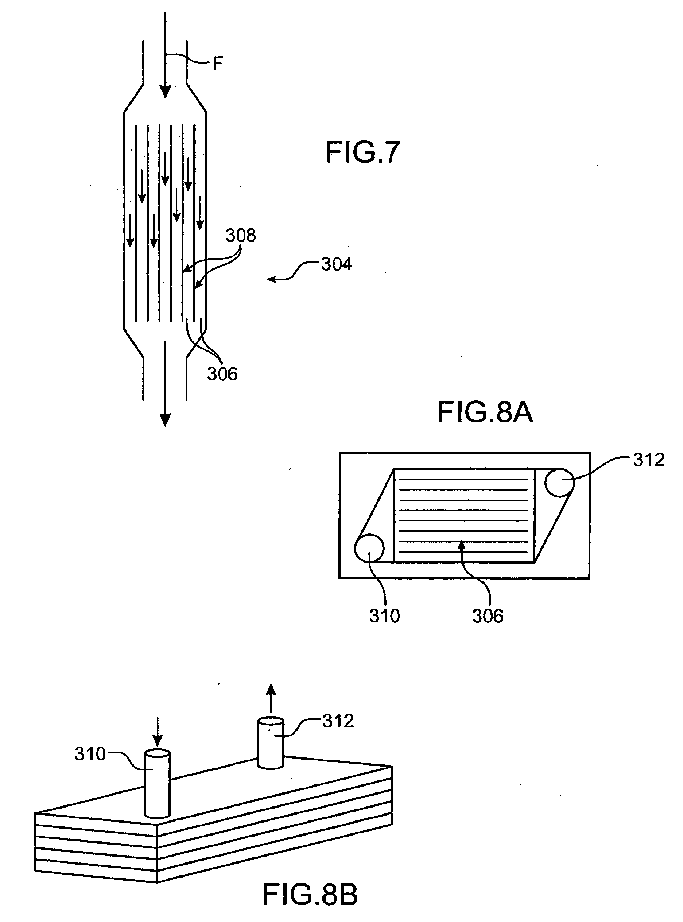

Sur la figure 7, on peut voir un exemple de réalisation d'un convertisseur photovoltaïque 304 selon l'invention, dans lequel les cellules photovoltaïques sont réalisées à partir de films minces, par exemple en polymère organique ou en film mince de CIS, CIGS ou CdTe.

Dans ce cet exemple, des canaux 306 sont délimités à l'intérieur de l'enceinte directement par des films minces 308 formant les cellules photovoltaïques, disposés parallèlement les uns par rapport aux autres.

Sur les figures 8A et 8B, on peut voir un exemple de connexion de ce type de convertisseur au circuit. On prévoit deux embouts 310, 312 su une face supérieure de l'enceinte à deux sommets opposés, l'un assurant l'arrivée du fluide, et l'autre assurant l'évacuation du fluide.

La collecte des électrons sur le film se fait de manière classique à l'aide d'électrodes métalliques déposées.

Nous allons maintenant décrire un procédé de réalisation d'un tel convertisseur.

Les films de cellules réalisées en polymère organique sont fabriqués de manière classique. Par exemple, les films sont réalisés préférentiellement en continu par la technique dite « roll to roll ».

Ensuite, les films sont assemblés par collage, en réalisant les connexions électriques des cellules entre elles, ce qui permet de réaliser les liaisons série/parallèle nécessaires.

Dans le cas de films par exemple en CIGS ou en CIS, ceux-ci sont déposés sur un polymère ou sur du métal.

La technique utilisée pour réaliser les films en CIS ou en CIGS est également préférentiellement en continu type « roll to roll ».

On prévoit d'assembler les films par collage, par soudure... en réalisant la connexion électrique des cellules entre elles permettant de réaliser les liaisons série/parallèle nécessaires

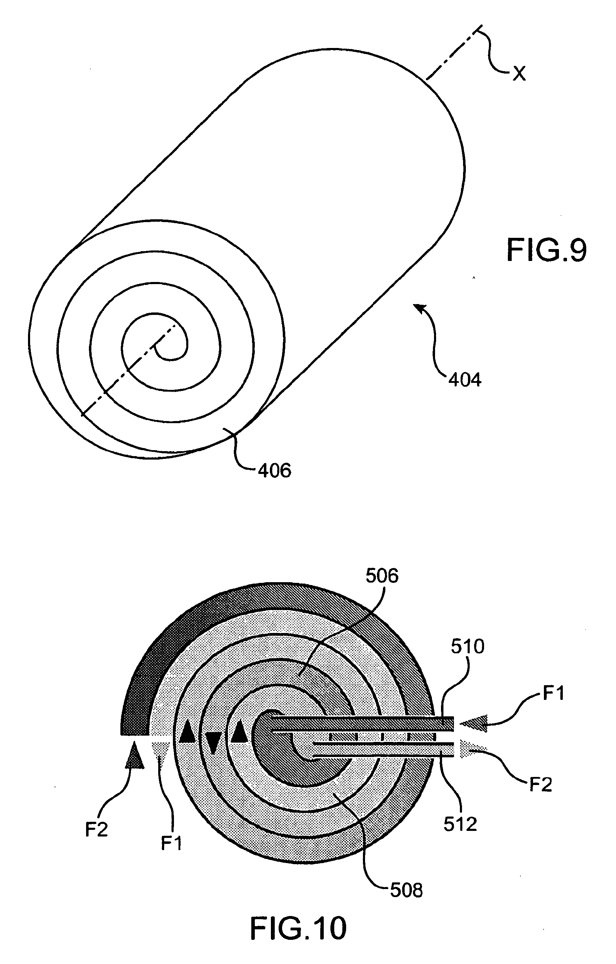

Sur les figures 9 et 10, on peut voir deux autres exemples de réalisation 404, 504 d'un convertisseur photovoltaïque réalisé à partir d'un film mince enroulé sur lui-même.

Sur la figure 9, le convertisseur comporte un canal 406 ménagé entre les différentes couches de l'enroulement pour permettre l'écoulement du fluide. Ce canal 406 peut être obtenu soit à l'aide d'espaceurs (non représentés) interposés entre les différentes couches de l'enroulement, soit par une structuration directe du film mince, par exemple par gaufrage. Le relief ainsi obtenu détermine le jeu entre les couches.

L écoulement peut avoir lieu soit selon l'axe X de l'enroulement, soit dans le sens de l'enroulément. Dans ce dernier, on prévoit des moyens pour amener le fluide ou l'évacuer au niveau de l'axe X de l'enroulement.

Dans le cas de la figure 10, le convertisseur 504 est formé par un double enroulement formant deux canaux 506, 508 enroulés l'une dans l'autre, permettant de faire circuler simultanément deux fluides F1 et F2 dans l'enroulement. Avantageusement, l'un F1 des fluides est le fluide chargé avec les particules photoluminescentes et l'autre fluide F2 est un fluide caloporteur destiné à extraire la chaleur du fluide photoluminescent. Le convertisseur forme alors également l'échangeur thermique. Pour cela on utilise un film mince rabattu et ensuite enroulé sur lui-même.

On prévoit au niveau de l'axe de l'enroulement X, l'alimentation 510 en fluide photoluminescent F1 et l'évacuation 512 du fluide caloporteur F2. De manière avantageuse, la circulation des fluides F1 et F2 s'effectue à contre courant améliorant l'efficacité des échanges thermiques.

De manière similaire au convertisseur de la figure 9, les films minces peuvent être avantageusement pourvus d'un développement de surface par réalisation de canaux obtenu par différents procédés, tels que la gravure, l'embossage, le gaufrage ou tout autre procédé.

On pourrait également prévoir de réaliser des conduits formés par des cellules photovoltaïques, c'est-à-dire intégrer le convertisseur dans la canalisation de circulation du fluide.

La présente invention est particulièrement intéressante en tant que système antidéflagrant, utilisé dans les zones où toute alimentation électrique est proscrite, telle que les zones explosives.

## Revendications

1. Dispositif de conversion photovoltaïque comportant une zone de captation (2) des photons apportés par le rayonnement lumineux (R) et une zone de conversion (4, 104, 204, 304, 404, 504) desdits photons en énergie électrique, la zone de captation (2) et la zone de conversion (4, 104, 204, 304, 404, 504) étant formées par des enceintes (8, 16) distinctes, un fluide chargé de particules photoluminescentes étant destiné à circuler entre la zone de captation (2) et la zone de conversion (4, 104, 204, 304, 404, 504), lesdites particules absorbant les photons et étant transportées jusqu'à la zone de conversion (4, 104, 204, 304, 404, 504) dans laquelle a lieu une réémission des photons par les particules.

2. Dispositif de conversion photovoltaïque selon la revendication 1, dans lequel les particules photoluminescentes sont des particules phosphorescentes.

3. Dispositif de conversion photovoltaïque selon la revendication 2, dans lequel les particules phosphorescentes sont des sulfures ou des séléniures ou des phosphores de type oxyde, de préférence les particules phosphorescentes sont des sulfures de zinc ou des aluminates d'alcalino-ferreux dopé.

4. Dispositif de conversion photovoltaïque selon l'une des revendications 1 à 4, dans lequel la concentration en masse des particules photoluminescentes est comprise entre 0,1% et 30% et dans lequel le fluide est un alcane ou un perfluroalcane.

5. Dispositif de conversion photovoltaïque selon l'une des revendications 1 à 4, dans lequel l'enceinte (8) de la zone de captation (2) comporte au moins une face (14) transparente au rayonnement lumineux (R) et l'enceinte (16) de la zone de conversion photovoltaïque (4, 104, 204, 304, 404, 504) a une partie au moins des faces intérieures de ses structures internes recouvertes de cellules photovoltaïques, chaque enceinte (8, 16) comportant un orifice d'alimentation (10, 18) et un orifice d'évacuation (12, 20) du fluide, l'orifice d'évacuation (12, 20) d'une enceinte (8, 16) étant connecté à l'orifice d'alimentation (18, 10) de l'autre enceinte (16, 8).

6. Dispositif de conversion photovoltaïque selon l'une des revendications 1 à 5, comportant un échangeur thermique, par exemple l'échangeur thermique est interposé entre la zone de captation et la zone de conversion, en amont de la zone de conversion.

7. Dispositif de conversion photovoltaïque selon l'une des revendications 1 à 6, dans lequel la zone de conversion (104, 204) comporte au moins une plaque dans laquelle sont gravées des canaux (106, 206) de circulation du fluide, les matériaux de la plaque et de la surface des canaux (106, 206) formant des jonctions p-n ou n-p.

8. Dispositif de conversion photovoltaïque selon la revendication précédente, dans lequel les canaux (106) sont contenus dans le plan de la plaque ou dans lequel les canaux (206) sont traversants et orthogonaux au plan de la plaque de sorte à former une membrane perforée.

9. Dispositif de conversion photovoltaïque selon la revendications 7 ou 8, comportant un empilement d'au moins deux plaques.

10. Dispositif de conversion photovoltaïque selon la revendication 9, dans lequel les plaques de l'empilement sont alimentées avec le fluide en parallèle.

11. Dispositif de conversion photovoltaïque selon la revendication 9 ou 10, dans lequel un échangeur thermique est interposé entre chaque paire de plaques de l'empilement.

12. Dispositif de conversion photovoltaïque selon l'une des revendications 1 à 6, dans lequel la zone de conversion (304, 404, 504) comporte des cellules photovoltaïques réalisées en film mince de polymère organiques ou de CIS, de CIGS ou de CdTe déposé sur métal ou verre.

13. Dispositif de conversion photovoltaïque selon la revendication précédente, comportant des canaux (306) délimités par les films minces.

14. Dispositif de conversion photovoltaïque selon la revendication 12, dans lequel le film mince est enroulé sur lui-même délimitant un canal (406, 506, 508) en forme de spiral.

15. Dispositif de conversion photovoltaïque selon la revendication précédente, comportant des entretoises entre les différents enroulements du film de sorte à maintenir écarter deux enroulements du film pour ménager le canal (406, 506, 508), celles-ci étant soit rapportées entre les enroulements, soit formées dans le film par gaufrage ou bossage de celui-ci.

16. Dispositif de conversion photovoltaïque selon la revendication 14, comportant deux canaux (506, 508) enroulés l'un autour de l'autre formés par pliage du film mince sur lui-même et par enroulage de ce film plié, l'un des canaux (506) étant destiné à la circulation du fluide chargé en particules photoluminescentes (F1) et l'autre canal (508) étant destiné à la circulation du fluide caloporteur (F2).

17. Procédé de réalisation d'un dispositif de conversion photovoltaïque selon l'une des revendications 7 à 11, comportant les étapes de réalisation de la zone de conversion suivantes :
- gravure de canaux (106, 206) dans un substrat (108, 208) en silicium dopé p ou n,
- réalisation d'un dopage (110) de type n ou p de la face intérieure des canaux (106 ,206), formant ainsi des zones émettrices de type n ou p et des zones collectrices de type p ou n,
- dépôt d'électrodes (112, 212, 114, 214) sur les zones émettrices et collectrices,
- recuit de ladite structure ainsi formée.

18. Procédé de réalisation d'un dispositif de conversion photovoltaïque selon la revendication précédente, comportant l'étape de dépôt d'un matériau anti-réfléchissant avant l'étape de dépôt des électrodes.

19. Procédé de réalisation d'un dispositif de conversion photovoltaïque selon la revendication 17 ou 18, comportant l'étape d'assemblage de plusieurs plaques empilées par collage ou brasure.

20. Procédé de réalisation d'un dispositif de conversion photovoltaïque selon l'une des revendications 12 à 16 comportant les étapes de :
- réalisation d'un film en polymère organique en en CIS, CIGS ou CdTe, par exemple par un procédé en continu de type « roll to roll »,
- enroulage du film sur lui-même en laissant un jeu entre les différentes couches de l'enroulement.

## Patentansprüche

1. Photovoltaik-Wandler, umfassend einen Empfangsbereich (2) für Photonen, die durch die Licht-Bestrahlung (R) herangetragen werden, und einen Umwandlungsbereich (4, 104, 204, 304, 404, 504) für die Photonen in elektrische Energie, wobei der Empfangsbereich (2) und der Umwandlungsbereich (4, 104, 204, 304, 404, 504) durch verschiedene abgeschlossene Gebiete (8, 16) gebildet sind, wobei ein Fluid, das mit photolumineszenten Teilchen beladen ist, dazu bestimmt ist, zwischen dem Empfangsbereich (2) und dem Umwandlungsbereich (4, 104, 204, 304, 404, 504) zu zirkulieren, wobei die Teilchen die Photonen absorbieren und zu dem Umwandlungsbereich (4, 104, 204, 304, 404, 504) transportiert werden, in welchem eine erneute Emission der Photonen durch die Teilchen stattfindet.

2. Photovoltaik-Wandler nach Anspruch 1, wobei die photolumineszenten Teilchen phosphoreszierende Teilchen sind.

3. Photovoltaik-Wandler nach Anspruch 2, wobei die phosphoreszierenden Teilchen Sulfide oder Selenide oder Phosphorverbindungen vom Oxid-Typ sind, wobei die phosphoreszierenden Teilchen vorzugsweise Zinksulfide oder dotierte Erdalkalialuminate sind.

4. Photovoltaik-Wandler nach einem der Ansprüche 1 bis 4, wobei die Massen-Konzentration der photolumineszenten Teilchen zwischen 0,1 % und 30 % liegt, und wobei das Fluid ein Alkan oder ein Perfluoralkan ist.

5. Photovoltaik-Wandier nach einem der Ansprüche 1 bis 4, wobei das abgeschlossene Gebiet (8) von dem Empfangsbereich (2) wenigstens eine Fläche (14) aufweist, die für die Licht-Bestrahlung (R) transparent ist, und wobei für das abgeschlossene Gebiet (16) von dem Photovoltaik-Umwandlungsbereich (4, 104, 204, 304, 404, 504) wenigstens ein Teil der inneren Flächen seiner internen Strukturen mit Photovoltaikzellen bedeckt ist, wobei jedes abgeschlossene Gebiet (8, 16) eine Versorgungsöffnung (10, 18) und eine Ableitungsöffnung (12, 20) für das Fluid umfasst, wobei die Ableitungsöffnung (12, 20) von einem abgeschlossenen Gebiet (8, 16) mit der Versorgungsöffnung (18, 10) von dem anderen abgeschlossenen Gebiet (16, 8) verbunden ist.

6. Photovoltaik-Wandler nach einem der Ansprüche 1 bis 7, umfassend einen Wärmetauscher, wobei beispielsweise der Wärmetauscher zwischen dem Empfangsbereich und dem Umwandlungsbereich angeordnet ist, stromaufwärts von dem Umwandlungsbereich.

7. Photovoltaik-Wandler nach einem der Ansprüche 1 bis 6, wobei der Umwandlungsbereich (104, 204) wenigstens eine Platte umfasst, in welche Kanäle (106, 206) hinein geätzt/graviert sind, für die Zirkulation des Fluids, wobei die Materialien der Platte und der Oberfläche der Kanäle (106, 206) Übergänge vom Typ p-n oder n-p bilden.

8. Photovoltalk-Wandier nach dem vorhergehenden Anspruch, wobei die Kanäle (106) in der Ebene der Platte enthalten sind, oder wobei die Kanäle (206) orthogonal zu der Ebene der Platte verlaufen und diese durchqueren, so dass eine perforierte Membran gebildet wird.

9. Photovoltaik-Wandler nach Anspruch 7 oder 8, umfassend einen Stapel von wenigstens zwei Platten.

10. Photovoltaik-Wandler nach Anspruch 9, wobei die Platten des Stapels parallel mit dem Fluid versorgt werden.

11. Photovoltaik-Wandler nach Anspruch 9 oder 10, wobei ein Wärmetauscher zwischen jedem Paar von Platten des Stapels angeordnet ist.

12. Photovoltaik-Wandler nach einem der Ansprüche 1 bis 6, wobei der Umwandlungsbereich (304, 404, 504) Photovoltaikzellen umfasst, die aus einer dünnen Schicht/Folie aus einem organischen Polymer oder aus CIS, CIGS oder CdTe hergestellt sind, aufgebracht auf Metall oder Glas.

13. Photovoltaik-Wandler nach dem vorhergehenden Anspruch, umfassend Kanäle (306), die durch die dünnen Schichten/Folien begrenzt sind.

14. Photovoltaik-Wandler nach Anspruch 12, wobei die dünne Schicht/Folie auf sich selbst aufgerollt ist, wodurch ein Kanal (406, 506, 508) in Spiral-Form begrenzt wird.

15. Photovoltaik-Wandler nach dem vorhergehenden Anspruch, umfassend Abstandhalter zwischen den unterschiedlichen Wicklungen der Schicht/Folie, so dass zwei Wicklungen der Schicht/Folie voneinander beabstandet gehalten werden, um den Kanal (406, 506, 508) zu erzeugen, wobei diese entweder zwischen die Wicklungen eingebracht werden oder in der Schicht/Folie durch Prägung oder Bearbeitung von dieser gebildet sind.

16. Photovoltaik-Wandler nach Anspruch 14, umfassend zwei Kanäle (506, 508) wobei der eine um den anderen gerollt ist, gebildet durch Falten der dünnen Schicht/Folie auf sich selbst und durch Aufrollen der gefalteten Schicht/Folie, wobei der eine der Kanäle (506) für die Zirkulation des mit photolumineszenten Teilchen beladenen Fluids (F1) bestimmt ist, und der andere Kanal (508) für die Zirkulation des Wärmeträger-Fluids (F2) bestimmt ist.

17. Verfahren zur Herstellung eines Photovoltaik-Wandlers nach einem der Ansprüche 7 bis 11, umfassend die folgenden Schritte für die Herstellung des Umwandlungsbereichs:
- Ätzen von Kanälen (106, 206) in ein Substrat (108, 208) aus p- oder n-dotiertem Silizium,
- Erzeugen einer Dotierung (110) vom Typ n oder p auf der inneren Fläche der Kanäle (106, 206) die so Emitter-Bereiche vom Typ n oder p und Kollektor-Bereiche vom Typ p oder n bilden,
- Aufbringen von Elektroden (112, 212, 114, 214) auf die Emitter-Bereiche und Kollektor-Bereiche,
- Ausheizen der so gebildeten Struktur.

18. Verfahren zur Herstellung eines Photovoltaik-Wandlers nach dem vorhergehenden Anspruch, umfassend den Schritt des Aufbringens von einem anti-reflektierenden Material vor dem Schritt des Aufbringens der Elektroden.

19. Verfahren zur Herstellung eines Photovoltaik-Wandlers nach Anspruch 17 oder 18, umfassend den Schritt der Montage von mehreren aufeinander gestapelten Platten durch Kleben oder Löten.

20. Verfahren zur Herstellung eines Photovoltaik-Wandlers nach einem der Ansprüche 12 bis 16, umfassend die Schritte:
- Herstellung einer Schicht/Folie aus einem organischen Polymer oder aus CIS, CIGS oder CdTe, beispielsweise durch ein kontinuierliches Verfahren vom Typ "Rolle zu Rolle",
- Aufrollen der Schicht/Folie auf sich selbst, wobei ein Abstand zwischen den unterschiedlichen Lagen der Wicklung belassen wird.

## Claims

1. A photovoltaic conversion device comprising an area (2) for collecting photons provided by the luminous radiation (R) and an area (4, 104, 204, 304, 404, 504) for converting said photons into electrical energy, the collecting area (2) and the converting area (4, 104, 204, 304, 404, 504) being formed by distinct enclosures (8, 16), a fluid loaded with photoluminescent particles being for flowing between the collecting area (2) and the converting area (4, 104, 204, 304, 404, 504), said particles absorbing photons and being conveyed to the converting area (4, 104, 204, 304, 404, 504) in which a reemission of the photons by the particles takes place.

2. The photovoltaic conversion device according to claim 1, wherein the photoluminescent particles are phosphorescent particles.

3. The photovoltaic conversion device according to claim 2, wherein the phosphorescent particles are sulphides or selenides or oxide type phosphors, advantageously the phosphorescent particles are zinc sulphides or doped alkaline ferrous aluminates.

4. The photovoltaic conversion device according to one of claims 1 to 3, wherein the mass concentration of the phosphorescent particles is between 0.1% and 30% and wherein the fluid is an alkane or a perfluoroalkane.

5. The photovoltaic conversion device according to one of claims 1 to 4, wherein the enclosure (8) of the collecting area (2) comprises at least one face (14) transparent to luminous radiation (R) and the enclosure (16) of the photovoltaic conversion area (4, 104, 204, 304, 404, 504) has a portion at least of the inner faces of its inner structures being covered with photovoltaic cells, each enclosure (8, 16) comprising a feeding port (10, 18) and a discharging port (12, 20) for the fluid, the discharging port (12, 20) of one enclosure (8, 16) being connected to the feeding port (18, 10) of the other enclosure (16, 8).

6. The photovoltaic conversion device according to one of claims 1 to 5, comprising a heat exchanger (22), advantageously the heat exchanger being located between the collecting area and the converting area, upstream of the converting area.

7. The photovoltaic conversion device according to one of claims 1 to 6, wherein the converting area (104, 204) comprises at least a plate wherein fluid flow channels (106, 206) are etched, the materials of the plate and of the surface of the channels (106, 206) forming p-n or n-p junctions.

8. The photovoltaic conversion device according to the preceding claim, wherein the channels (106) are contained in the plane of the plate or wherein the channels (206) are through channels and orthogonal to the plane of the plate so as to form a perforated membrane.

9. The photovoltaic conversion device according to claim 7 or 8, comprising a stack of at least two plates.

10. The photovoltaic conversion device according to claim 9, wherein the plates of the stack are fed with the fluid in parallel.

11. The photovoltaic conversion device according to claim 9 or 10, wherein a heat exchanger is sandwiched between each pair of plates of the stack.

12. The photovoltaic conversion device according to one of claims 1 to 6, wherein the converting area (304, 404, 504) comprises photovoltaic cells made of a thin film of organic polymers or CIS, CIGS or CdTe deposited on metal or glass.

13. The photovoltaic conversion device according to the preceding claim, comprising channels (306) bounded by the thin films.

14. The photovoltaic conversion device according to claim 12, wherein the thin film is wound around itself bounding a spiral-shaped channel (406, 506, 508).

15. The photovoltaic conversion device according to the preceding claim, comprising spacers between different windings of the film so as to maintain two windings of the film away from each other to provide the channel (406, 506, 508), the spacers either being fastened between the windings, or formed in the film by die-pressing or embossing thereof.

16. The photovoltaic conversion device according to claim 14, comprising two channels (506, 508) wound round one another formed by folding the thin film back on itself and by winding this folded back film, one of the channels (506) being for the flow of the fluid loaded with photoluminescent particles (F1) and the other channel (508) being for the flow of the heat transfer fluid (F2).

17. A method for manufacturing a photovoltaic conversion device according to one of claims 7 to 11, comprising the following steps of making the conversion area:
- etching channels (106, 206) in a substrate (108, 208) of p- or n-doped silicon,
- making a n- or p-type doping (110) of the inner face of the channels (106, 206), thus forming nor p-type emitting areas and p- or n-type collecting areas,
- depositing electrodes (112, 212, 114, 214) onto the emitting and collecting areas,
- annealing said structure thus formed.

18. The method for manufacturing a photovoltaic conversion device according to the preceding claim, comprising the step of depositing an antireflecting material before the step of depositing the electrodes.

19. The method for manufacturing a photovoltaic conversion device according to claim 17 or 18, comprising the step of assembling several stacked plates by bonding or soldering.

20. The method for manufacturing a photovoltaic conversion device according to one of claims 12 to 16, comprising the steps of:
- making a film of organic polymer of CIS, CIGS or CdTe, for example by a "roll to roll" type continuous method,
- winding the film round itself leaving a clearance between the different layers of the winding.
